(19)

**Europäisches Patentamt**

**European Patent Office**

**Office européen des brevets**

(11) **EP 4 518 580 A1**

(12) **EUROPEAN PATENT APPLICATION**

(43) Date of publication:
05.03.2025 Bulletin 2025/10

(21) Application number: 23194766.4

(22) Date of filing: 01.09.2023

(51) International Patent Classification (IPC):
*H05B 6/06* (2006.01)　　　*H05B 6/42* (2006.01)

(52) Cooperative Patent Classification (CPC):
H05B 6/06; B23K 9/235; B23K 9/32; B23K 11/34;
B23K 11/36; B23K 15/0026; B23K 15/0033;
B23K 26/60; B23K 26/702; B23K 31/02;
B23K 37/00; B23K 37/003; H05B 6/42

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Pemamek OY**
**32200 Loimaa (FI)**

(72) Inventor: **KORKEAKANGAS, Niko**
**Loimaa (FI)**

(74) Representative: **Berggren Oy**
**P.O. Box 16**
**Eteläinen Rautatiekatu 10A**
**00101 Helsinki (FI)**

(54) **DEVICE AND METHOD FOR PREHEATING A WORKPIECE TO BE WELDED**

(57)　　The present invention relates to a device (100) and a method for preheating a workpiece (200) to be welded. The device (100) comprises a liquid-cooled induction coil (101) arrangeable in connection with the workpiece (200), a power supply unit (102) configured to supply AC power to the liquid-cooled induction coil (101), and a cooling unit (105) configured to convey cooling liquid through the liquid-cooled induction coil (101). The present invention also relates to a welding system.

Fig. 1

EP 4 518 580 A1

## Description

### TECHNICAL FIELD OF THE INVENTION

The present invention relates to a device and a method for preheating a workpiece to be welded according to the preambles of the appended independent claims. The invention also relates to a welding system.

### BACKGROUND OF THE INVENTION

Many welding applications require preheating, which involves heating the area around the weld joint or the entire workpiece to a desired temperature before welding. Preheating reduces the temperature difference between the welding arc and the workpiece, which decreases the cooling rate of the weld. The slower cooling rate provides more time for hydrogen to defuse from the weld zone, which reduces the risk of cracking and the potential for a failed weld. Preheating also drives moisture out of the area to be welded, which improves welding quality.

Various devices, such as induction heaters, electrical resistance heaters, and torches, are commonly used for preheating a workpiece before welding. An induction heater comprises induction coils for creating a magnetic field that generates eddy currents within the workpiece, thus heating the workpiece internally. An electrical resistance heater comprises electrically heated elements for transferring heat through radiation and conduction to the workpiece. A torch heats the workpiece with a flame that is directed to the surface of the workpiece. In some of the known preheating devices, the amount of heat that is transferred to the workpiece can be controlled based on the temperatures of an area of the workpiece before and after preheating.

A problem associated with the known preheating devices is that they are ineffective and inefficient in some situations. Another problem associated with the known preheating devices is the difficulty of preheating a workpiece to a desired temperature with minimal temperature variation throughout the welding process.

### OBJECTIVES OF THE INVENTION

It is the main objective of the present invention to reduce or even eliminate the prior art problems presented above.

It is an objective of the present invention to provide a device and a method for preheating a workpiece to be welded. It is also an objective of the invention to provide a device and a method enabling to preheat a workpiece effectively and efficiently before and/or during welding. It is a further objective of the invention to provide a device and a method enabling to preheat a workpiece to a desired temperature with minimal temperature variation throughout the welding process. It is yet a further objective of the invention to provide a device and a method enabling to easily and precisely control the amount of heat energy that is transferred to a workpiece to be welded.

It is also an objective of the present invention to provide a system for welding a workpiece. It is a further objective of the invention to provide a welding system enabling to achieve a high welding quality.

In order to realise the above-mentioned objectives, the device and the method according to the invention are characterised by what is presented in the characterising portions of the appended independent claims. Advantageous embodiments of the invention are described in the dependent claims.

### DESCRIPTION OF THE INVENTION

A device according to the invention for preheating a workpiece to be welded comprises a liquid-cooled induction coil arrangeable in connection with the workpiece, a power supply unit configured to supply AC power to the liquid-cooled induction coil, and a cooling unit configured to convey cooling liquid through the liquid-cooled induction coil.

The device according to the invention is meant for heating a workpiece to a desired temperature before and/or during welding. The power supply unit is electrically connected to the liquid-cooled induction coil, and it is used for supplying AC power to the liquid-cooled induction coil. When AC power is supplied to the liquid-cooled induction coil that is arranged in connection with the workpiece, the liquid-cooled induction coil creates a magnetic field that generates eddy currents within the workpiece, as a result of which the workpiece is heated. The amount of energy that is induced into the workpiece can be controlled by changing the AC power supplied to the liquid-cooled induction coil, and/or by changing the distance between the liquid-cooled induction coil and the workpiece. The cooling unit is used for cooling the liquid-cooled induction coil by conveying the cooling liquid through the liquid-cooled induction coil. The cooling liquid can be, for example, water, a mixture of water and glycol, or oil.

An advantage of the device according to the invention is that a workpiece to be welded can be preheated effectively and efficiently. Another advantage of the device according to the invention is that a workpiece can be preheated to a desired temperature with minimal temperature variation throughout a welding process. Yet another advantage of the device according to the invention is that the amount of heat energy that is transferred to a workpiece to be welded can be easily and precisely controlled.

According to an embodiment of the invention the device comprises means for determining the amount of energy induced into the workpiece. This enables to evaluate whether the workpiece has been preheated enough.

According to an embodiment of the invention the means for determining the amount of energy induced into the workpiece comprises means for determining the amount of energy supplied to the liquid-cooled induction coil, means for determining the amount of energy lost as heat in the liquid-cooled induction coil, and means for calculating the amount of energy induced into the workpiece based on the determined amount of energy supplied to the liquid-cooled induction coil and the determined amount of energy lost as heat in the liquid-cooled induction coil. The amount of energy that is induced into the workpiece can be calculated by subtracting the determined amount of energy that is lost as heat in the liquid-cooled induction coil from the determined amount of energy that is supplied to the liquid-cooled induction coil. The means for determining the amount of energy supplied to the liquid-cooled induction coil may comprise a power consumption meter that can be integrated into the power supply unit.

According to an embodiment of the invention the means for determining the amount of energy lost as heat in the liquid-cooled induction coil comprises means for determining the temperature of the cooling liquid before and after the liquid-cooled induction coil, means for determining the flow rate of the cooling liquid, and means for calculating the amount of energy lost as heat in the liquid-cooled induction coil based on the determined temperature of the cooling liquid before and after the liquid-cooled induction coil and the determined flow rate of the cooling liquid. The amount of energy that is lost as heat in the liquid-cooled induction coil can be calculated from the following equation:

$$E_{loss} = \rho c_p Q (T_{out} - T_{in}) t$$

where $\rho$ denotes the density of the cooling liquid, $c_p$ denotes the specific heat capacity of the cooling liquid, Q denotes the flow rate, $T_{out}$ denotes the temperature of the cooling liquid after it has passed through the liquid-cooled induction coil, $T_{in}$ denotes the temperature of the cooling liquid before it has passed through the liquid-cooled induction coil, and t denotes the time of measurement.

The means for determining the temperature of the cooling liquid before and after the liquid-cooled induction coil may comprise a first temperature sensor for measuring the temperature of the cooling liquid before it has passed through the liquid-cooled induction coil, and a second temperature sensor for measuring the temperature of the cooling liquid after it has passed through the liquid-cooled induction coil. The first and the second temperature sensor can be integrated into the cooling unit or attached to hoses that convey the cooling liquid between the cooling unit and the liquid-cooled induction coil. The first and the second temperature sensor can be, for example, a negative temperature coefficient (NTC) thermistor, a resistance temperature detector (RTD), a thermocouple, or a semiconductor-based integrated (IC) sensor.

The means for determining the flow rate of the cooling liquid may comprise a flow meter that can be integrated into the cooling unit or attached to one of the hoses that convey the cooling liquid between the cooling unit and the liquid-cooled induction coil. The flow meter can be, for example, a Coriolis, differential pressure, vortex, magnetic, ultrasonic, turbine or positive displacement meter.

According to an embodiment of the invention the cooling unit is configured to convey the cooling liquid through the power supply unit. The cooling unit is used for cooling the power supply unit.

According to an embodiment of the invention the means for determining the amount of energy induced into the workpiece comprises means for determining the amount of energy supplied to the power supply unit, means for determining the amount of energy lost as heat in the liquid-cooled induction coil and the power supply unit, and means for calculating the amount of energy induced into the workpiece based on the determined amount of energy supplied to the power supply unit and the determined amount of energy lost as heat in the liquid-cooled induction coil and the power supply unit.

According to an embodiment of the invention the means for determining the amount of energy lost as heat in the liquid-cooled induction coil and the power supply unit comprises means for determining the temperature of the cooling liquid before and after the liquid-cooled induction coil and the power supply unit, means for determining the flow rate of the cooling liquid, and means for calculating the amount of energy lost as heat in the liquid-cooled induction coil and the power supply unit based on the determined temperature of the cooling liquid before and after the liquid-cooled induction coil and the power supply unit and the determined flow rate of the cooling liquid.

According to an embodiment of the invention the device comprises means for controlling the AC power supplied to the liquid-cooled induction coil based on the determined amount of energy induced into the workpiece. This enables to reduce the temperature variations in the preheated workpiece.

According to an embodiment of the invention the means for controlling the AC power supplied to the liquid-cooled induction coil based on the determined amount of energy induced into the workpiece comprises means for comparing the determined amount of energy induced into the workpiece to a predetermined threshold value, means for increasing the AC power supplied to the liquid-cooled induction coil if the determined amount of energy induced into the workpiece is smaller than the predetermined threshold value, and means for decreasing the AC power supplied to the liquid-cooled induction coil if the determined amount of energy induced into the workpiece is larger than the predetermined threshold value.

According to an embodiment of the invention the device comprises means for determining the temperature of the workpiece before and after preheating, and means for controlling the AC power supplied to the liquid-cooled induction coil based on the determined temperature of the workpiece before and after preheating. This enables to reduce the temperature variations in the preheated workpiece. The means for determining the temperature of the workpiece before and after preheating may comprise a first temperature sensor for measuring the temperature of the workpiece before preheating, and a second temperature sensor for measuring the temperature of the workpiece after preheating. The first and the second temperature sensor can be, for example, a negative temperature coefficient (NTC) thermistor, a resistance temperature detector (RTD), a thermocouple, or a semiconductor-based integrated (IC) sensor.

According to an embodiment of the invention the device comprises means for determining the speed of the workpiece with respect to the liquid-cooled induction coil, and means for controlling the AC power supplied to the liquid-cooled induction coil based on the determined speed of the workpiece with respect to the liquid-cooled induction coil. This enables to reduce the temperature variations in the preheated workpiece. The means for determining the speed of the workpiece with respect to the liquid-cooled induction coil may comprise a speed sensor that is attached to the liquid-cooled induction coil.

According to an embodiment of the invention the device comprises means for moving the liquid-cooled induction coil and the workpiece with respect to each other.

According to an embodiment of the invention the device comprises means for adjusting the distance between the liquid-cooled induction coil and the workpiece based on the determined amount of energy induced into the workpiece. This enables to reduce the temperature variations in the preheated workpiece.

The present invention also relates to a welding system. The welding system according to the invention comprises a device for welding a workpiece and a device according to the invention for preheating the workpiece.

An advantage of the welding system according to the invention is that it can provide a high welding quality.

The present invention also relates to a method for preheating a workpiece to be welded. The method according to the invention comprises arranging a liquid-cooled induction coil in connection with the workpiece, moving the liquid-cooled induction coil and the workpiece with respect to each other, supplying AC power to the liquid-cooled induction coil, and conveying cooling liquid through the liquid-cooled induction coil.

The method according to the invention is meant for heating a workpiece to a desired temperature before and/or during welding. In the method according to the invention, the liquid-cooled induction coil is used as a heating device. When AC power is supplied to the liquid-cooled induction coil, the liquid-cooled induction coil creates a magnetic field that generates eddy currents within the workpiece, as a result of which the workpiece is heated. The amount of energy that is induced into the workpiece can be controlled by changing the AC power supplied to the liquid-cooled induction coil, and/or by changing the distance between the liquid-cooled induction coil and the workpiece. The AC power that is supplied to the liquid-cooled induction coil can be, for example, 0-150 kW depending on the material thickness, target temperature and travel speed. The liquid-cooled induction coil can be arranged in contact with or at a distance from the workpiece. The distance between the liquid-cooled induction coil and the workpiece can be, for example, less than 6 mm.

In the method according to the invention, the liquid-cooled induction coil and the workpiece are moved with respect to each other. The method according to the invention can thus be employed in various continuous welding applications. The liquid-cooled induction coil can be moved with respect to the workpiece, or vice versa using suitable moving means. The relative speed between the liquid-cooled induction coil and the workpiece can be, for example, 500-3000 mm/min.

In the method according to the invention, the cooling liquid is conveyed through the liquid-cooled induction coil. The temperature of the cooling liquid that is conveyed to the liquid-cooled induction coil can be, for example, 20-40 °C. The flow rate of the cooling liquid that is conveyed through the liquid-cooled induction coil can be, for example, 5-30 l/min, or 15-25 l/min. Typically, the flow rate is kept constant.

An advantage of the method according to the invention is that a workpiece to be welded can be preheated effectively and efficiently. Another advantage of the method according to the invention is that a workpiece can be preheated to a desired temperature with minimal temperature variation throughout a welding process. Yet another advantage of the method according to the invention is that the amount of heat energy that is transferred to a workpiece to be welded can be easily and precisely controlled. Yet another advantage of the method according to the invention is that insufficient and excessive preheating of a workpiece can be avoided. Insufficient or excessive preheating is known to decrease material properties of a workpiece.

According to an embodiment of the invention the method comprises determining the amount of energy induced into the workpiece. By determining the amount of energy that is induced into the workpiece it can be evaluated whether the workpiece has been preheated enough.

According to an embodiment of the invention the step of determining the amount of energy induced into the workpiece comprises determining the amount of energy supplied to the liquid-cooled induction coil, determining the amount of energy lost as heat in the liquid-cooled induction coil, and calculating the amount of energy induced into the workpiece based on the determined amount of energy supplied to the liquid-cooled induction coil and the determined amount of energy lost as heat in the liquid-cooled induction coil.

According to an embodiment of the invention the step of determining the amount of energy lost as heat in the liquid-cooled induction coil comprises determining the temperature of the cooling liquid before and after the liquid-cooled induction coil, determining the flow rate of the cooling liquid, and calculating the amount of energy lost as heat in the liquid-cooled induction coil based on the determined temperature of the cooling liquid before and after the liquid-cooled induction coil and the determined flow rate of the cooling liquid.

According to an embodiment of the invention the method comprises conveying the cooling liquid through the power supply unit.

According to an embodiment of the invention the step of determining the amount of energy induced into the workpiece comprises determining the amount of energy supplied to the power supply unit, determining the amount of energy lost as heat in the liquid-cooled induction coil and the power supply unit, and calculating the amount of energy induced into the workpiece based on the determined amount of energy supplied to the power supply unit and the determined amount of energy lost as heat in the liquid-cooled induction coil and the power supply unit.

According to an embodiment of the invention the step of determining the amount of energy lost as heat in the liquid-cooled induction coil and the power supply unit comprises determining the temperature of the cooling liquid before and after the liquid-cooled induction coil and the power supply unit, determining the flow rate of the cooling liquid, and calculating the amount of energy lost as heat in the liquid-cooled induction coil and the power supply unit based on the determined temperature of the cooling liquid before and after the liquid-cooled induction coil and the power supply unit and the determined flow rate of the cooling liquid.

According to an embodiment of the invention the method comprises controlling the AC power supplied to the liquid-cooled induction coil based on the determined amount of energy induced into the workpiece. By controlling the supplied AC power based on the induced energy the temperature variations in the preheated workpiece can be reduced.

According to an embodiment of the invention the step of controlling the AC power supplied to the liquid-cooled induction coil based on the determined amount of energy induced into the workpiece comprises comparing the determined amount of energy induced into the workpiece to a predetermined threshold value, if the determined amount of energy induced into the workpiece is smaller than the predetermined threshold value, increasing the AC power supplied to the liquid-cooled induction coil, and if the determined amount of energy induced into the workpiece is larger than the predetermined threshold value, decreasing the AC power supplied to the liquid-cooled induction coil.

According to an embodiment of the invention the method comprises determining the temperature of the workpiece before and after preheating, and controlling the AC power supplied to the liquid-cooled induction coil based on the determined temperature of the workpiece before and after preheating. By controlling the supplied AC power based on the before and after temperatures the temperature variations in the preheated workpiece can be reduced.

According to an embodiment of the invention the method comprises determining the speed of the workpiece with respect to the liquid-cooled induction coil, and controlling the AC power supplied to the liquid-cooled induction coil based on the determined speed of the workpiece with respect to the liquid-cooled induction coil. By controlling the supplied AC power based on the relative speed between the workpiece and the liquid-cooled induction coil the temperature variations in the preheated workpiece can be reduced.

According to an embodiment of the invention the method comprises adjusting the distance between the liquid-cooled induction coil and the workpiece based on the determined amount of energy induced into the workpiece. By adjusting the distance between the liquid-cooled induction coil and the workpiece based on the induced energy the temperature variations in the preheated workpiece can be reduced.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

The exemplary embodiments presented in this text and their advantages relate by applicable parts to the device as well as the method according to the invention, even though this is not always separately mentioned.

BRIEF DESCRIPTION OF THE DRAWINGS

Fig. 1    illustrates a schematic view of a preheating device according to a first embodiment of the invention,

fig. 2    illustrates a schematic view of a preheating device according to a second embodiment of the invention,

fig. 3    illustrates a schematic view of a preheating device according to a third embodiment of the invention, and

fig. 4    illustrates the use of a welding system according to an embodiment of the invention for welding a windmill tower section.

DETAILED DESCRIPTION OF THE DRAWINGS

The same reference signs are used of the same or like components in different embodiments.

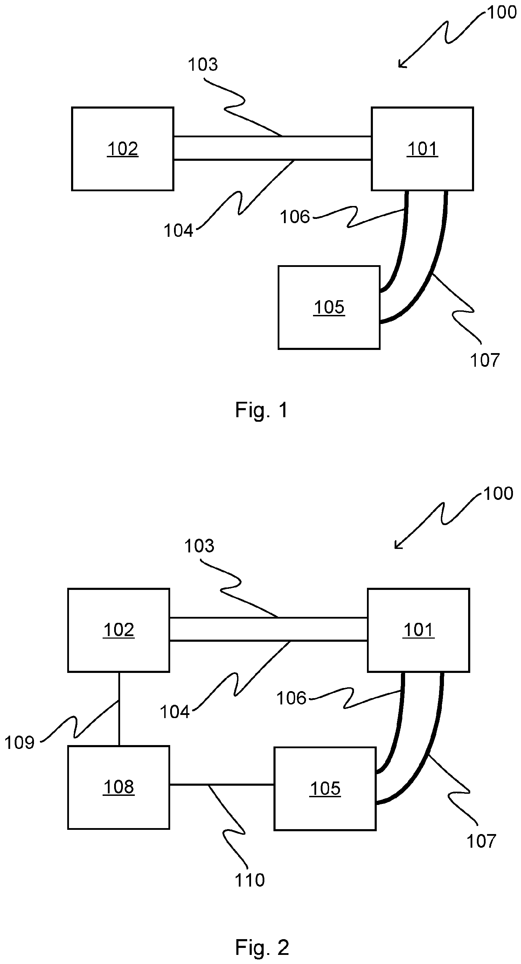

Fig. 1 illustrates a schematic view of a preheating device according to a first embodiment of the invention. The preheating device 100 is meant for heating a workpiece to a desired temperature before and/or during welding.

The preheating device 100 comprises a liquid-cooled induction coil 101 that can be arranged in connection with the workpiece. The liquid-cooled induction coil 101 is powered by a power supply unit 102 that is electrically connected to the liquid-cooled induction coil 101 with cables 103 and 104. When the power supply unit 102 supplies AC power to the liquid-cooled induction coil 101, the liquid-cooled induction coil 101 creates a magnetic field that can generate eddy currents within the workpiece, as a result of which the workpiece is heated. The amount of energy that is induced into the workpiece can be controlled by changing the AC power supplied to the liquid-cooled induction coil 101, and/or by changing the distance between the liquid-cooled induction coil 101 and the workpiece.

The preheating device 100 comprises a cooling unit 105 that is connected to the liquid-cooled induction coil 101 with hoses 106 and 107. The cooling unit 105 circulates cooling liquid via the hoses 106 and 107 through the liquid-cooled induction coil 101, whereby the liquid-cooled induction coil 101 is cooled.

Fig. 2 illustrates a schematic view of a preheating device according to a second embodiment of the invention. The preheating device of fig. 2 differs from the preheating device of fig. 1 in that it additionally comprises a control unit 108 for controlling the AC power that is supplied to the liquid-cooled induction coil 101. The control unit 108 is connected to the power supply unit 102 with a communication line 109, and to the cooling unit 105 with a communication line 110.

The control unit 108 comprises a processor and a memory including computer program code, the memory and the computer program code being configured to, with the processor, perform the following tasks. The control unit 108 is configured to receive from the cooling unit 105 the flow rate of the cooling liquid and the temperatures of the cooling liquid that is conveyed to and received from the liquid-cooled induction coil 101, and to calculate the amount of energy lost as heat in the liquid-cooled induction coil 101 based on the flow rate and temperatures of the cooling liquid. The control unit 108 is configured to receive from the power supply unit 102 the amount of energy that is supplied to the liquid-cooled induction coil 101 and to calculate the amount of energy induced into the workpiece based on the amount of energy supplied to the liquid-cooled induction coil 101 and the amount of energy lost as heat in the liquid-cooled induction coil 101. The control unit 108 is configured to control the AC power supplied to the liquid-cooled induction coil 101 based on the calculated amount of energy induced into the workpiece.

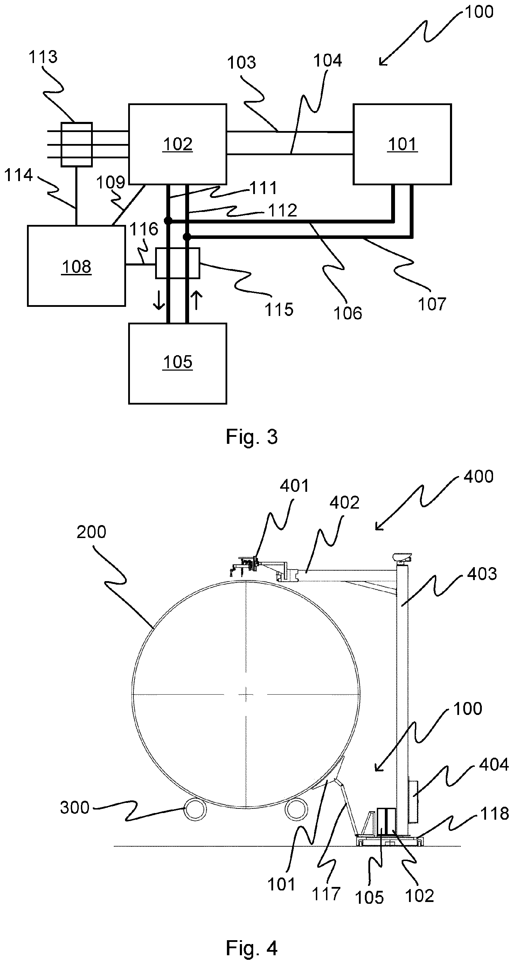

Fig. 3 illustrates a schematic view of a preheating device according to a third embodiment of the invention. The preheating device 100 is meant for heating a workpiece to a desired temperature before and/or during welding.

The preheating device 100 comprises a liquid-cooled induction coil 101 that can be arranged in connection with the workpiece. The liquid-cooled induction coil 101 is powered by a power supply unit 102 that is electrically connected to the liquid-cooled induction coil 101 with cables 103 and 104. When the power supply unit 102 supplies AC power to the liquid-cooled induction coil 101, the liquid-cooled induction coil 101 creates a magnetic field that can generate eddy currents within the workpiece, as a result of which the workpiece is heated. The amount of energy that is induced into the workpiece can be controlled by changing the AC power supplied to the liquid-cooled induction coil 101, and/or by changing the distance between the liquid-cooled induction coil 101 and the workpiece.

The preheating device 100 comprises a cooling unit 105 that is connected to the liquid-cooled induction coil 101 with hoses 106 and 107, and to the power supply unit 102 with hoses 111 and 112. The cooling unit 105 circulates cooling liquid via the hoses 106, 107, 111 and 112 through the liquid-cooled induction coil 101 and the power supply unit 102, whereby the liquid-cooled induction coil 101 as well as the power supply unit 102 are cooled. The flow direction is marked with arrows. The preheating device 100 comprises a control unit 108 for controlling the AC power that is supplied to the liquid-cooled induction coil 101. The control unit 108 is connected to the power supply unit 102 with a communication line 109.

The control unit 108 is connected to a measuring instrument 113 with a communication line 114. The measuring instrument 113 determines the amount of energy that is supplied to the power supply unit 102. The control unit 108 is also connected to a measuring instrument 115 with a communication line 116. The measuring instrument 115 determines the flow rate of the cooling liquid and the temperatures of the cooling liquid that is conveyed to and received from the liquid-cooled induction coil 101 and the power supply unit 102.

The control unit 108 comprises a processor and a memory including computer program code, the memory and the computer program code being configured to, with the processor, perform the following tasks. The control unit 108 is configured to receive from the measuring instrument 115 the flow rate and the temperatures of the cooling liquid, and to calculate the amount of energy lost as heat in the liquid-cooled induction coil 101 and the power supply unit 102 based on the flow rate and temperatures of the cooling liquid. The control unit 108 is also configured to receive from the measuring instrument 113 the amount of energy that is supplied to the power supply unit 102 and to calculate the amount of energy induced into the workpiece based on the amount of energy supplied to the power supply unit 102 and the amount of energy lost as heat in the liquid-cooled induction coil 101 and the power supply unit 102. The control unit 108 is configured to control the AC power supplied to the liquid-cooled induction coil 101 based on the calculated amount of energy induced into the workpiece.

Fig. 4 illustrates the use of a welding system according to an embodiment of the invention for welding a windmill tower section. The windmill tower section 200 is placed on two rotatable rollers 300 that enable the windmill tower section 200 to be rotated around its longitudinal axis. In the arrangement of fig. 4, the windmill tower section 200 is rotated in a counter-clockwise direction.

The welding system comprises a preheating device 100. The preheating device 100 comprises a liquid-cooled induction coil 101 and a movable arm 117 whose first end is attached to the liquid-cooled induction coil 101. A second end of the movable arm 117 is attached to a base 118. The liquid-cooled induction coil 101 is arranged using the movable arm 117 close to a surface of the windmill tower section 200. The preheating device 100 comprises a power supply unit 102 that is configured to supply AC power to the liquid-cooled induction coil 101, and a cooling unit 105 that is configured to convey cooling liquid through the liquid-cooled induction coil 101. The power supply unit 102 and the cooling unit 105 are placed on the base 118.

The welding system comprises a welding device 400. The welding device 400 comprises a welding head 401 that is attached with an arm 402 to a tower 403 that is supported on the base 118. The welding device 400 comprises a power supply unit 404 that supplies the needed electrical power to the welding head 401.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A device for preheating a workpiece to be welded, **characterised in that** the device comprises:

   - a liquid-cooled induction coil arrangeable in connection with the workpiece,
   - a power supply unit configured to supply AC power to the liquid-cooled induction coil, and

   - a cooling unit configured to convey cooling liquid through the liquid-cooled induction coil.

2. The device according to claim 1, **characterised in that** the device comprises means for determining the amount of energy induced into the workpiece.

3. The device according to claim 2, **characterised in that** the means for determining the amount of energy induced into the workpiece comprises:

   - means for determining the amount of energy supplied to the liquid-cooled induction coil,
   - means for determining the amount of energy lost as heat in the liquid-cooled induction coil, and
   - means for calculating the amount of energy induced into the workpiece based on the determined amount of energy supplied to the liquid-cooled induction coil and the determined amount of energy lost as heat in the liquid-cooled induction coil.

4. The device according to claim 3, **characterised in that** the means for determining the amount of energy lost as heat in the liquid-cooled induction coil comprises:

   - means for determining the temperature of the cooling liquid before and after the liquid-cooled induction coil,
   - means for determining the flow rate of the cooling liquid, and
   - means for calculating the amount of energy lost as heat in the liquid-cooled induction coil based on the determined temperature of the cooling liquid before and after the liquid-cooled induction coil and the determined flow rate of the cooling liquid.

5. The device according to any of claims 2 to 4, **characterised in that** the device comprises means for controlling the AC power supplied to the liquid-cooled induction coil based on the determined amount of energy induced into the workpiece.

6. The device according to claim 5, **characterised in that** the means for controlling the AC power supplied to the liquid-cooled induction coil based on the determined amount of energy induced into the workpiece comprises:

   - means for comparing the determined amount of energy induced into the workpiece to a predetermined threshold value,
   - means for increasing the AC power supplied to the liquid-cooled induction coil if the determined amount of energy induced into the workpiece is smaller than the predetermined threshold value, and

- means for decreasing the AC power supplied to the liquid-cooled induction coil if the determined amount of energy induced into the workpiece is larger than the predetermined threshold value.

7. The device according to any of the preceding claims, **characterised in that** the device comprises:

   - means for determining the speed of the workpiece with respect to the liquid-cooled induction coil, and
   - means for controlling the AC power supplied to the liquid-cooled induction coil based on the determined speed of the workpiece with respect to the liquid-cooled induction coil.

8. A welding system comprising a device for welding a workpiece, **characterised in that** the welding system comprises a device according to any of the preceding claims for preheating the workpiece.

9. A method for preheating a workpiece to be welded, **characterised in that** the method comprises:

   - arranging a liquid-cooled induction coil in connection with the workpiece,
   - moving the liquid-cooled induction coil and the workpiece with respect to each other,
   - supplying AC power to the liquid-cooled induction coil, and
   - conveying cooling liquid through the liquid-cooled induction coil.

10. The method according to claim 9, **characterised in that** the method comprises determining the amount of energy induced into the workpiece.

11. The method according to claim 10, **characterised in that** the step of determining the amount of energy induced into the workpiece comprises:

   - determining the amount of energy supplied to the liquid-cooled induction coil,
   - determining the amount of energy lost as heat in the liquid-cooled induction coil, and
   - calculating the amount of energy induced into the workpiece based on the determined amount of energy supplied to the liquid-cooled induction coil and the determined amount of energy lost as heat in the liquid-cooled induction coil.

12. The method according to claim 11, **characterised in that** the step of determining the amount of energy lost as heat in the liquid-cooled induction coil comprises:

   - determining the temperature of the cooling liquid before and after the liquid-cooled induction coil,
   - determining the flow rate of the cooling liquid, and
   - calculating the amount of energy lost as heat in the liquid-cooled induction coil based on the determined temperature of the cooling liquid before and after the liquid-cooled induction coil and the determined flow rate of the cooling liquid.

13. The method according to any of claims 10 to 12, **characterised in that** the method comprises controlling the AC power supplied to the liquid-cooled induction coil based on the determined amount of energy induced into the workpiece.

14. The method according to claim 13, **characterised in that** the step of controlling the AC power supplied to the liquid-cooled induction coil based on the determined amount of energy induced into the workpiece comprises:

   - comparing the determined amount of energy induced into the workpiece to a predetermined threshold value,
   - if the determined amount of energy induced into the workpiece is smaller than the predetermined threshold value, increasing the AC power supplied to the liquid-cooled induction coil, and
   - if the determined amount of energy induced into the workpiece is larger than the predetermined threshold value, decreasing the AC power supplied to the liquid-cooled induction coil.

15. The method according to any of claims 9 to 14, **characterised in that** the method comprises:

   - determining the speed of the workpiece with respect to the liquid-cooled induction coil, and
   - controlling the AC power supplied to the liquid-cooled induction coil based on the determined speed of the workpiece with respect to the liquid-cooled induction coil.

Fig. 1

Fig. 2

Fig. 3

Fig. 4

Europäisches
Patentamt

European
Patent Office

Office européen
des brevets

# EUROPEAN SEARCH REPORT

**Application Number**

EP 23 19 4766

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/338312 A1 (GOLDAMMER MATTHIAS [DE] ET AL) 20 October 2022 (2022-10-20) | 1-6,8-14 | INV.<br>H05B6/06 |
| Y | * abstract *<br>* figures 1,2 *<br>* paragraphs [0029] – [0046] *<br>* claims 1-7 * | 7,15 | H05B6/42 |
| Y | WO 2015/175066 A1 (ILLINOIS TOOL WORKS [US]) 19 November 2015 (2015-11-19) | 7,15 | |
| A | * abstract *<br>* paragraphs [0052], [0053], [0059], [0077], [0139] – [0144] *<br>* claim 1 * | 1-6,8-14 | |
| A | US 11 224 934 B2 (ILLINOIS TOOL WORKS [US]) 18 January 2022 (2022-01-18)<br>* abstract *<br>* column 8, line 4 – column 9, line 20 *<br>* column 12, lines 3-49 *<br>* column 15, lines 1-45 *<br>* claims 1,18 * | 1-15 | |
| | | | TECHNICAL FIELDS SEARCHED (IPC) |
| A | WO 2006/132839 A1 (ILLINOIS TOOL WORKS [US]; THOMAS JEFFREY R [US] ET AL.) 14 December 2006 (2006-12-14)<br>* abstract *<br>* paragraphs [0016], [0017], [0028] – [0031] *<br>* claims 1-4,13,17 *<br>* figures 1,2,7 * | 1-15 | H05B<br>B23K |

The present search report has been drawn up for all claims

| Place of search | Date of completion of the search | Examiner |
|---|---|---|
| Munich | 7 February 2024 | de la Tassa Laforgue |

EPO FORM 1503 03.82 (P04C01)

## ANNEX TO THE EUROPEAN SEARCH REPORT
## ON EUROPEAN PATENT APPLICATION NO.

EP 23 19 4766

This annex lists the patent family members relating to the patent documents cited in the above-mentioned European search report.
The members are as contained in the European Patent Office EDP file on
The European Patent Office is in no way liable for these particulars which are merely given for the purpose of information.

07-02-2024

| Patent document cited in search report | | | Publication date | Patent family member(s) | | | Publication date |
|---|---|---|---|---|---|---|---|
| US 2022338312 | A1 | | 20-10-2022 | CN | 114364474 | A | 15-04-2022 |
| | | | | EP | 3796752 | A1 | 24-03-2021 |
| | | | | EP | 3984332 | A1 | 20-04-2022 |
| | | | | US | 2022338312 | A1 | 20-10-2022 |
| | | | | WO | 2021052815 | A1 | 25-03-2021 |
| WO 2015175066 | A1 | | 19-11-2015 | CA | 2948473 | A1 | 19-11-2015 |
| | | | | CN | 106489298 | A | 08-03-2017 |
| | | | | EP | 3143835 | A1 | 22-03-2017 |
| | | | | MX | 361347 | B | 04-12-2018 |
| | | | | US | 2015334780 | A1 | 19-11-2015 |
| | | | | WO | 2015175066 | A1 | 19-11-2015 |
| US 11224934 | B2 | | 18-01-2022 | CN | 111491756 | A | 04-08-2020 |
| | | | | EP | 3727735 | A1 | 28-10-2020 |
| | | | | US | 2019193191 | A1 | 27-06-2019 |
| | | | | WO | 2019126629 | A1 | 27-06-2019 |
| WO 2006132839 | A1 | | 14-12-2006 | EP | 1889516 | A1 | 20-02-2008 |
| | | | | US | 2006289492 | A1 | 28-12-2006 |
| | | | | WO | 2006132839 | A1 | 14-12-2006 |

EPO FORM P0459

For more details about this annex : see Official Journal of the European Patent Office, No. 12/82